# EUROPÄISCHE PATENTSCHRIFT

(11) **EP 0 424 647 B1**
(45) Veröffentlichungstag und Bekanntmachung des Hinweises auf die Patenterteilung: **03.08.1994**
(21) Anmeldenummer: 90117041.5
(22) Anmeldetag: 05.09.1990
(51) Int. Cl.: H01L 25/07, H01L 23/373

(54) **Leistungshalbleiterbauelement mit Trägerplatten**
Power semiconductor component having carrier plates
Composant semi-conducteur de puissance comprenant des plaques de support

(30) Priorität: 22.09.1989 DE 3931634
(43) Veröffentlichungstag der Anmeldung: 02.05.1991
(73) Patentinhaber: TEMIC TELEFUNKEN microelectronic GmbH, 74072 Heilbronn (DE)
(72) Erfinder: Viehmann, Rainer-Kurt, D-7102 Lehrensteinsfeld (DE)
(74) Vertreter: Maute, Hans-Jürgen, Dipl.-Ing.

(56) Entgegenhaltungen:
- EP-A- 0 078 075
- EP-A- 0 101 335
- EP-A- 0 198 621
- FR-A- 2 244 264
- US-A- 4 563 383

## Beschreibung

Die Erfindung betrifft ein Leistungshalbleiterbauelement mit einem geringen Wärmewiderstand gemäß dem Oberbegriff des Patentanspruches 1.

Aus dem Konferenzbericht "Power-Transistor-Chips on heat sink: Evaluation of different mounting techniques" veröffentlicht in "5th European Hybrid Microelectronics Conference 1985, Stresa - Italy", Seiten 245 - 258, insbesondere Tabelle 1 und 2, wo solche Leistungshalbleiterbauelemente mit jeweils verschiedenen Aufbauten dargestellt und bezüglich ihren Eigenschaften untersucht worden sind. Hierbei geht es besonders um Leistungshalbleiterbauelemente für Endstufen von elektronischen Zündmodulen für Kraftfahrzeuge. Solche elektronischen Zündmodule bestehen gewöhnlich aus einem Hybridschaltkreis, der nur einen geringen Teil der in dem Modul umgesetzten Leistung verbraucht, und Leistungstransistoren in Darlington-Schaltung, die den Zündspulenstrom schalten und somit einer großen Strombelastung ausgesetzt sind. Diese Strombelastung führt natürlich zu einer großen Wärmeentwicklung im Bereich des Halbleiterchips, die über Wärmesenken abgeführt werden muß.

Insbesondere im Bereich des Kraftfahrzeugbaues ist an die Elektronik, also beispielsweise für das genannte elektronische Zündmodul, eine enorm hohe Forderung an deren Zuverlässigkeit gestellt, so daß die Ausfallraten nur wenige ppm pro Jahr betragen dürfen. Deswegen sind im Zusammenhang mit der Wärmeabfuhr an den Aufbau eines Leistungsbauelementes im Hinblick auf die Zuverlässigkeit besonders hohe Anforderungen zu stellen.

Gemäß der genannten Veröffentlichung ist ein typischer Aufbau eines solchen Leistungshalbleiterbauelementes dadurch gegeben, daß der Halbleiterchip mittelbar über einen isolierenden Träger, beispielsweise aus Berylliumoxid (BeO), auf eine Aluminiumplatte, die als Wärmesenke dient, aufgelötet ist. Alternativ hierzu kann das Leistungshalbleiterbauelement auch zuerst auf eine Kupferplatte aufgelötet sein, bevor es ebenfalls über einen isolierenden Träger, beispielsweise aus Aluminiumoxid (Al₂O₃), auf einer als Wärmesenke dienenden weiteren Platte angeordnet wird. Das für die Wirksamkeit des Aufbaues entscheidende Kriterium ist hierbei der Wärmewiderstand, der für die beiden genannten Ausführungen mit der in der Tabelle 1 auf Seite 248 der genannten Veröffentlichung angegebenen Meßwerte von 0,35 bzw. 0,5 K/W beträgt.

Dieser Wärmewiderstand hängt neben den Wärmeleitfähigkeiten der benannten Trägerelemente auch von der Wärmeleitfähigkeit des zum Verbinden der einzelnen Elemente erforderlichen Lotes ab. Zudem dient die Lotschicht zwischen den Elementen, beispielsweise zwischen dem Halbleiterchip und dem Berylliumoxid-Träger bzw. der Kupfer-Platte gemäß der genannten Veröffentlichung, siehe Seite 247, letzter Absatz, auch zur Aufnahme der durch unterschiedliche Längenausdehnungen benachbarte Elemente bedingten mechanischen Scherkräfte, stellt also eine Pufferschicht bezüglich dieser mechanischen Spannungen dar. Deswegen muß diese Lotschicht bezüglich der Schichtdicke und der Zusammensetzung im Hinblick auf diese Aufgaben optimiert werden.

Schließlich kommt die genannte Veröffentlichung auf Seite 255, erster Absatz zu dem Ergebnis, daß nur ein Aufbau mit einer Berylliumoxid-Platte gemäß des Typs E bis G (siehe Tabelle 2) den Anforderungen bezüglich der Zuverlässigkeit genügt.

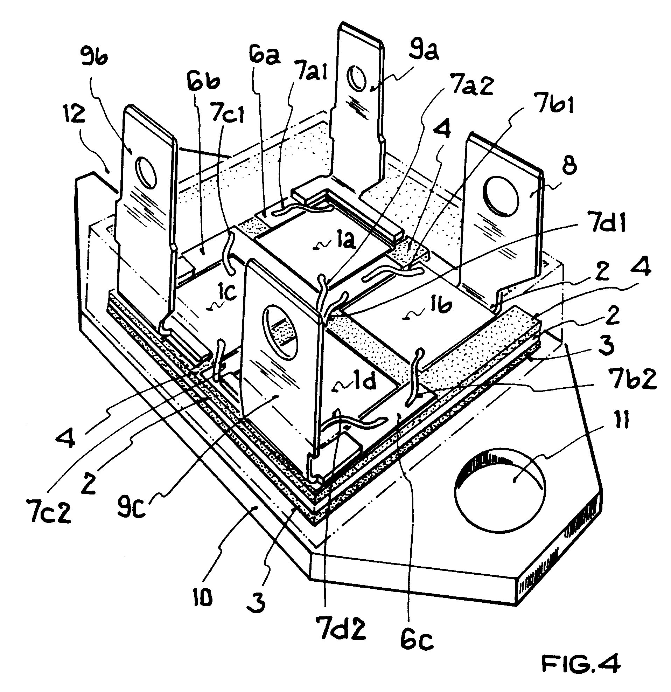

Jedoch ist die Verwendung von Berylliumoxid aufgrund seiner Umweltschädlichkeit abzulehnen, womit der empfohlene Aufbau eines Leistungshalbleiterbauelementes mittels eines Berylliumoxid-Trägers nicht durchführbar ist. Als Alternative bietet sich dann der ebenfalls schon genannte Aufbau mit einer Kupfer-Platte und einem Aluminiumoxid-Träger (Typ A) an bzw. statt der Kupfer-Platte eine Platte aus Kupfer-Kovar (Typ B und C). Es zeigt sich jedoch, daß diese Ausführung gemäß den Figuren 4, 5 und 6 auf den Seiten 251 und 252 der genannten Veröffentlichung nach einer gewissen Anzahl von Testzyklen enorme Degradationserscheinungen bzw. eine Wärmewiderstandszunahme von mehr als 100 % zeigen.

Der Vollständigeit wegen wird noch auf die Druckschrift EP-A 0 101 335 sowie EP-A 0 198 621 hingewiesen. Die erstgenannte Druckschrift betrifft ein Gehäuse für einen integierten Schaltkreis, beispielsweise auf der Basis von GaAs für GHz-Frequenzen, insbesondere im Mikrowellenbereich. Der den integrierten Schaltkreis darstellende scheibenförmige Leistungshalbleiterkörper ist auf einer aus Kupfer bestehenden, ersten Trägerplatte gelötet, die ihrerseits auf einer metallischen, zweiten Trägerplatte angeordnet ist. Diese erste Trägerplatte trägt einen den Leistungshalbleiterkörper umschließenden, isolierenden Rahmen. Auf diesem isolierenden Rahmen sind Mikrowellen-Streifenleitungen, sog. "Mikrostrip"-Leitungen angeordnet, wobei die kupferne, erste Trägerplatte die Masseleitung dieser "Mikrostrip"-Leitungen bildet.

Ebenso offenbart die zweite Druckschrift einen auf einer Metallplatte montierten Leistungshalbleiterkörper, wobei diese Metallplatte die Masseleitung für "Mikrostrip"-Leitungen vom Koplanar-Leitungstyp bildet und auf einem isolierenden Substrat angeordnet ist. Zusammen mit einer Haube wird ein Gehäuse für den Leistungshalbleiterkörper gebildet, das dazu dient, den Leistungshalbleiterkörper mittels Hochgeschwindigkeitsleitungen an diejenigen einer Leiterplatte anzupassen.

Die Aufgabe der vorliegenden Erfindung besteht daher darin, einen Aufbau für ein Leistungshalbleiterbauelement der eingangs genannten Art anzugeben, der einen geringen Wärmewiderstand sowie eine geringe Degradation des Wärmewiderstandes von höchstens 1 K/W aufweist.

Gemäß der Erfindung wird diese Aufgabe durch die kennzeichnenden Merkmale des Patentanspruches 1 gelöst.

Das Wesen der Erfindung besteht also darin, daß die aus Kupfer bestehende erste Trägerplatte, auf der der Leistungshalbleiterkörper aufgelötet ist, mittels einer Stabilisierungsplatte mechanisch stabilisiert wird, so daß sie erst hierdurch als Trägerplatte geeignet ist.

Bei Verwendung von Reinstkupfer für die erste Trägerplatte gemäß einer vorteilhaften Weiterbildung der Erfindung wird der Wärmewiderstand der Anordnung weiter gesenkt, wobei diese Trägerplatte wiederum ihre Stabilität durch die Stabilisierungsplatte erhält. Ferner beträgt die Dicke einer solchen Trägerplatte bei einer weiteren bevorzugten Ausbildung der Erfindung mindestens 10 mm, wodurch die von dem Leistungshalbleiterkörper erzeugte Wärme optimal abgeführt wird.

Gemäß einer weiteren vorteilhaften Weiterbildung der Erfindung besteht die Stabilisierungsplatte aus Keramik, beispielsweise aus Aluminiumoxid (Al₂O₃) mit einer Dicke von ca. 0,38 - 0,63 mm. Hierdurch ergibt sich eine ausgezeichnete Stabilität der unter dieser Keramikplatte angeordneten kupfernen, ersten Trägerplatte, wobei die Gewichtszunahme des Leistungshalbleiterbauelementes vernachlässigbar ist, was insbesondere im Kraftfahrzeugbau ein wesentlicher Faktor darstellt. Schließlich ist auch eine solche Keramikplatte leicht, beispielsweise mittels Laser bearbeitbar. Gemäß einer anderen bevorzugten Ausführungsform besteht die zweite Trägerplatte aus Aluminiumoxid (Al₂O₃) oder Aluminiumnitrid (AlN).

Ein scheibenförmiger Leistungshalbleiterkörper weist in der Regel wenigstens an seiner Oberseite einen flächenmäßig eng begrenzten elektrischen Anschlußkontakt auf, der gemäß einer besonders vorteilhaften Weiterbildung der Erfindung mit der Oberseite der beidseitig, (beispielsweise mit Nickel) metallisierten Stabilisierungsplatte über eine elektrische Verbindungsleitung verbunden ist. Ferner wird bei einer Weiterbildung einer solchen Ausführungsform der Erfindung eine flächenhafte Anschlußfahne mit der auf der Oberseite der Stabilisierungsplatte angeordneten Metallschicht verlötet, wobei diese Anschlußfahne dem eng begrenzten Anschlußkontakt auf der Oberseite des Leistungshalbleiterkörpers zugeordnet ist und sich hierdurch eine einfache Kontaktierung des Leistungshalbleiterkörpers ergibt.

Weist schließlich das erfindungsgemäße Leistungshalbleiterbauelement mehrere scheibenförmige Leistungshalbleiterkörper auf, so enthält gemäß einer besonders bevorzugten Ausführungsform der Erfindung die Stabilisierungsplatte für jeden Leistungshalbleiterkörper eine besondere Aussparung, in die jeweils ein Leistungshalbleiterkörper eingefügt wird. Die auf der Oberseite der Stabilisierungsplatte angeordnete Metallisierungsschicht wird zur Bildung von Leitbahnen derart strukturiert, daß die elektrischen Verbindungsleitungen der Leistungshalbleiterkörper zwecks deren Verschaltung mit diesen Leitbahnen verbunden sind. Zur Erzielung einer einfachen Kontaktierung der Leistungshalbleiterkörper sind bei einer weiteren vorteilhaften Ausführungsform flächenhaft ausgebildete Anschlußfahnen mit den Leitbahnen verlötet.

Gemäß einer weiteren vorteilhaften Weiterbildung der Erfindung weist die kupferne, erste Trägerplatte eine integrierte, flächenhaft ausgebildete Anschlußfahne auf, die beispielsweise den Substratanschluß des Leistungshalbleiterkörpers oder den gemeinsamen Substratanschluß von mehreren Leistungshalbleiterkörpern darstellt.

Bei einer weiteren bevorzugten Ausführungform der Erfindung wird die isolierende, zweite Trägerplatte auf eine Grundplatte, die zusammen mit einer Gehäusehaube das Gehäuse bildet, angeordnet. In einer Fortbildung dieser Ausführungsform besteht diese Grundplatte aus Kupfer.

Im folgenden soll noch anhand von Ausführungsbeispielen die Erfindung sowie deren Vorteile in Verbindung mit den Zeichnungen dargestellt und erläutert werden. Es zeigen:
- Figur 1: eine schematische, perspektivische Darstellung eines ersten Ausführungsbeispiels der Erfindung,
- Figur 2: eine Draufsicht einer weiteren Ausführungsform des erfindungsgemäßen Leistungshalbleiterbauelementes,
- Figur 3: eine Schnittdarstellung der Ausführungsform gemäß Figur 2 und
- Figur 4: eine perspektivische Darstellung des Ausführungsbeispieles gemäß Figur 2.

In den Zeichnungen sind einander entsprechende Teile mit den gleichen Bezugszeichen versehen.

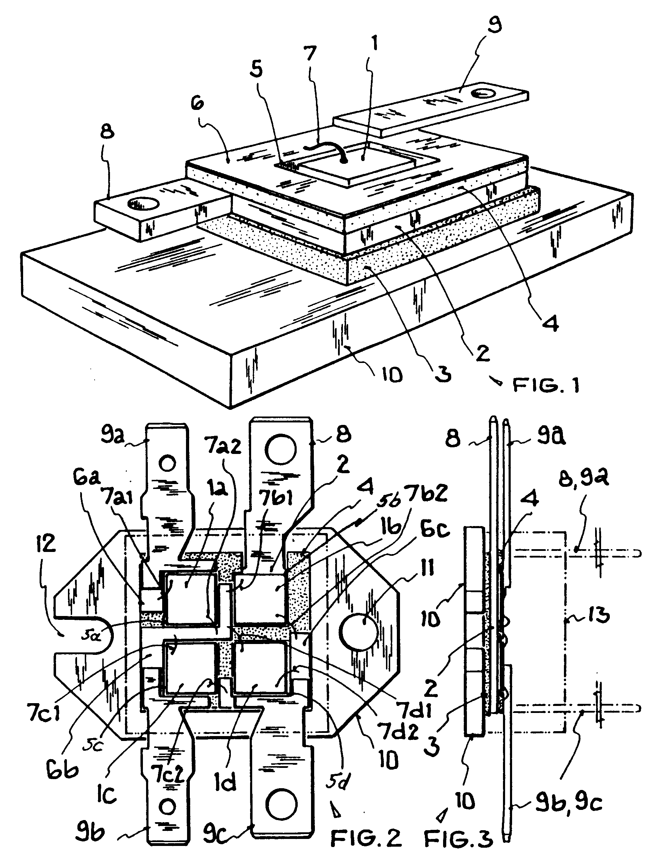

Der schematisch dargestellte Aufbau eines Ausführungsbeispiels der Erfindung gemäß Figur 1 zeigt einen scheibenförmigen, beispielsweise einen Leistungstransistor darstellenden Leistungshalbleiterkörper 1, der auf einer ersten Trägerplatte 2, beispielsweise mit PbSn- oder PbSnCu-Weichlot von ca. 50 - 80 µm, aufgelötet ist. Diese erste Trägerplatte 2 ist aus Reinstkupfer (d. h., der Legierungsanteil beträgt weniger als 0,1 %) hergestellt, so daß sie an sich als Trägerplatte nicht geeignet ist, die jedoch durch Verwendung einer erfindungsgemäßen Stabilisierungsplatte 4, beispielsweise aus Aluminiumoxid, ausreichend stabilisiert wird. Diese Stabilisierungsplatte 4 ist beidseitig metallisiert, beispielsweise mit Nickel, und auf die erste Trägerplatte 2 weichgelötet, wobei in einer Öffnung 5 dieser Stabilisierungsplatte 4 der scheibenförmige Leistungshalbleiterkörper 1 eingesetzt ist. Hierbei ist die Öffnung 5 so ausgebildet, daß deren Rand den Leistungshalbleiterkörper 1 beabstandet umgibt. Eine Verbindungsleitung 7 verbindet einen flächenmäßig eng begrenzten elektrischen Anschlußkontakt des Leistungshalbleiterkörpers 1 mit der Metallisierungsschicht 6 auf der Oberseite der Stabilisierungsplatte 4 und dient somit zur Kontaktierung des Leistungshalbleiterkörpers 1.

Zum elektrischen Anschließen des Leistungshalbleiterbauelements dient eine flächige Anschlußfahne 9, beispielsweise aus Kupfer, die im Bereich der äußeren Kante der Stabilisierungsplatte 4 mit der oberen Metallisierungsschicht 6 über eine Weichlotschicht elektrisch leitend verbunden ist. Eine weitere flächige Anschlußfahne 8 ist einstückig mit der kupfernen, ersten Trägerplatte 2 verbunden und dient als Substratanschluß für den Leistungshalbleiterkörper 1.

Schließlich wird diese Anordnung über eine isolierende, zweite Trägerplatte 3, beispielsweise aus Aluminiumoxid, auf eine kupferne Grundplatte 10, die eine Wärmesenke darstellt, aufgelötet. Um dies zu ermöglichen, ist diese zweite Trägerplatte 3 metallisiert, beispielsweise mit Nickel. Zur Herstellung eines guten Wärmekontaktes zwischen den aneinandergrenzenden Teilen ist auch die kupferne, erste Trägerplatte 2 als auch die kupferne Grundplatte 10 vernickelt, wobei der Kontakt jeweils über eine Weichlotschicht hergestellt wird, die auch die unterschiedlichen Längenausdehnungen puffert, insbesondere diejenigen des Leistungshalbleiterkörpers 1 und die diesen Leistungshalbleiterkörper 1 tragenden ersten Trägerplatte 2.

Abschließend wird diese in der Figur 1 dargestellte Anordnung in ein Gehäuse eingebracht, wobei die Grundplatte 10 als Gehäuseboden dient, und der Leistungshalbleiterkörper 1 sowie die Stabilisierungsplatte 4 mit einer Schutzschicht aus Kunststoff (Guß- oder Mouldmasse) bedeckt wird, was jedoch in dieser Figur 1 nicht gezeigt ist, da ein solches Gehäuse sowie eine solche Schutzschicht nicht zur Erfindung gehören.

Mit einer solchen gemäß Figur 1 beschriebenen Anordnung kann ein Wärmewiderstand von weniger als 1 K/W erzielt werden, wobei auch nach Testzyklen von mehr als 40.000 Temperatur-Zyklen keine wesentliche Degradation des Wärmewiderstandes feststellbar ist.

Die Figuren 2, 3 und 4 zeigen in einer Draufsicht, einer Schnittansicht und in einer perspektivischen Ansicht ein Leistungsmodul mit vier Leistungstransistoren 1a, 1b, 1c und 1d, die in diesem Modul als Darlington-Stufe verschaltet sind.

Der grundsätzliche Aufbau dieses Moduls entspricht demjenigen der Figur 1, also mit einer Grundplatte 10, auf der über eine zweite Trägerplatte 3 aus Aluminiumoxid oder Aluminiumnitrid eine erste, die vier Leistungshalbleiterkörper 1a, 1b, 1c und 1d tragende, erste Trägerplatte 2 angeordnet ist. Auch diese erste Trägerplatte 2 besteht aus Reinstkupfer, auf der eine Stabilisierungsplatte 4 aus Aluminiumoxid zur mechanischen Stabilisierung dieser ersten Trägerplatte 2 angeordnet ist. Ferner enthält diese Stabilisierungsplatte 4 vier quadratische Durchbrüche 5a, 5b, 5c und 5d, in die jeweils ein Leistungshalbleiterkörper eingefügt ist, so daß jeder der Leistungshalbleiterkörper 1a bis 1d von der Stabilisierungsplatte 4 rahmenförmig umgeben wird. Darüber hinaus ist die Unterseite der Stabilisierungsplatte 4 vernickelt und mit der ebenfalls vernickelten, kupfernen, ersten Trägerplatte 2 über eine Weichlotschicht verlötet. Auch die vier Leistungshalbleiterkörper 1a bis 1d sind auf dieser ersten Trägerplatte 2 weichgelötet, mit einer Lotdicke von ca. 60 µm. Die kupferne, erste Trägerplatte 2 dient zugleich als gemeinsamer Kollektoranschluß für die vier Leistungstransistorchips 1a bis 1d, weshalb eine flächige Anschlußfahne 8 einstückig mit der ersten Trägerplatte 2 verbunden ist.

Zur Verschaltung der Leistungshalbleiterkörper 1a bis 1d sind auf der Oberfläche der Stabilisierungsplatte 4 voneinander isolierte Leitbahnen 6a, 6b und 6c angeordnet. Weiterhin ist mit jeweils einer Leitbahn 6a, 6b und 6c eine flächige Anschlußfahne 9a, 9b und 9c verbunden, indem diese aus Kupfer hergestellten Anschlußfahnen im Randbereich der Stabilisierungsplatte 4 auf die Leitbahnen 6a, 6b und 6c aufgelötet sind. Im einzelnen stellt die Anschlußfahne 9a den Basis-Anschluß der Darlington-Stufe dar, der über die Leitbahn 6a und über eine Verbindungsleitung 7a₁ mit der Basis-Elektrode des Leistungstransistorchips 1a verbunden ist. Ferner sind die Basis-Elektroden der Leistungstransistorchips 1b, 1c und 1d sowie die Emitter-Elektrode des Leistungstransistorchips 1a jeweils über eine Verbindungsleitung 7b₁, 7c₁, 7d₁ und 7a₂ mit der Leitbahn 6b verbunden und führt über die Anschlußfahne 9b zum zweiten Basis-Anschluß der Darlington-Stufe. Schließlich bildet die Anschlußfahne 9c den Emitter-Anschluß des Darlington, der über die Leitbahn 6c und den mit ihr verbundenen Anschlußleitungen 7b₂, 7c₂ und 7d₂ jeweils zu den Emitter-Elektroden der Leistungstransistorchips 1b, 1c und 1d führen. Somit trägt die Stabilisierungsplatte 4 ein Verschaltungs-Layout, wodurch das Leistungshalbleiterbauelement, also dieses Leistungsmodul, zu einem "quasimonolithischen" Bauelement wird. Ein Vorteil eines solchen Bauelementes besteht darin, daß die Leistungstransistorchips 1a bis 1d eigenschaftsspezifisch vom Meßautomat aus der Chipfertigung ausgewählt werden können, um beispielsweise kundenspezifische Anforderungen an das Leistungsbauelement erfüllen zu können. So können z. B. die Leistungstransistorchips 1a bis 1d mit im wesentlichen identischen elektrischen Daten selektiert werden, was beispielsweise bei einer Einchip-Lösung - also alle vier Leistungstransistoren auf einem Chip - nur unter Inkaufnahme einer niedrigen Fertigungsausbeute erzielbar ist.

Bevor die auf der Grundplatte 10 aufgebaute Anordnung mit einem geeigneten Kunststoffgehäuse 13 gemäß Figur 3 und 4 vervollständigt wird, werden die Anschlußfahnen 8, 9a, 9b und 9c entsprechend der gestrichelten Darstellung in der Figur 3 gebogen. Abschließend wird noch eine Kunststoffverguß- bzw. Mouldmasse in das Gehäuse eingebracht. Zur weiteren Befestigung des Leistungsbauelementes weist die Grundplatte 10 auf deren gegenüberliegenden Seiten Flanschteile mit jeweils einer Bohrung 11 bzw. einem ovalen Durchbruch 12 auf.

Die Erfindung ist natürlich nicht nur auf eine Anordnung gemäß der Figur 1 oder 4 beschränkt, sondern ist auch für einen hybriden Aufbau verwendbar, so z. B. in einem eingangs erwähnten Zündmodul für Kraftfahrzeuge.

## Patentansprüche

1. Leistungshalbleiterbauelement mit einem geringen Wärmewiderstand, bei dem mindestens ein auf einer aus Kupfer bestehenden ersten Trägerplatte (2) aufgelöteter scheibenförmiger Leistungshalbleiterkörper (1) auf einer zweiten Trägerplatte (3) angeordnet ist, dadurch gekennzeichnet, daß die zweite Trägerplatte (3) elektrisch isolierend ist, daß auf der ersten Trägerplatte (2) eine mit einer Aussparung (5) versehene, elektrisch isolierende Stabilisierungsplatte (4) angeordnet ist, und daß ferner in diese Aussparung (5) der Stabilisierungsplatte (4) der scheibenförmige Leistungshalbleiterkörper (1) eingefügt ist.

2. Leistungshalbleiterbauelement nach Anspruch 1, dadurch gekennzeichnet, daß die kupferne, erste Trägerplatte (2) aus Reinstkupfer besteht.

3. Leistungshalbleiterbauelement nach Anspruch 1 oder 2, dadurch gekennzeichnet, daß der Wärmeausdehnungskoeffizient der Stabilisierungsplatte (4) kleiner ist als derjenige der kupfernen, ersten Trägerplatte (2).

4. Leistungshalbleiterbauelement nach einem der vorangehenden Ansprüche, dadurch gekennzeichnet, daß die Stabilisierungsplatte (4) aus Keramik besteht.

5. Leistungshalbleiterbauelement nach Anspruch 4, dadurch gekennzeichnet, daß die Stabilisierungsplatte (4) aus Aluminiumoxid (Al₂O₃) besteht.

6. Leistungshalbleiterbauelement nach Anspruch 5, dadurch gekennzeichnet, daß die Stabilisierungsplatte (4) eine Dicke von 0,38 - 0,63 mm aufweist.

7. Leistungshalbleiterbauelement nach einem der vorangehenden Ansprüche, dadurch gekennzeichnet, daß die Dicke der kupfernen, ersten Trägerplatte (2) mindestens 10 mm beträgt.

8. Leistungshalbleiterbauelement nach einem der vorangehenden Ansprüche, dadurch gekennzeichnet, daß die isolierende, zweite Trägerplatte (3) aus Aluminiumoxid (Al₂O₃) oder Aluminiumnitrid (AlN) besteht.

9. Leistungshalbleiterbauelement nach einem der vorangehenden Ansprüche, bei dem der scheibenförmige Leistungshalbleiterkörper (1) an seiner Oberseite mindestens einen flächenmäßig eng begrenzten elektrischen Anschlußkontakt aufweist, dadurch gekennzeichnet, daß die Stabilisierungsplatte (4) beidseitig metallisiert ist, und daß von der Metallisierungsschicht (6) auf der Oberseite der Stabilisierungsplatte (4) eine elektrische Verbindungsleitung (7) zu dem eng begrenzten Anschlußkontakt des Leistungshalbleiterkörpers (1) führt.

10. Leistungshalbleiterbauelement nach Anspruch 9, dadurch gekennzeichnet, daß eine dem flächenmäßig eng begrenzten Anschlußkontakt auf der Oberseite des Leistungshalbleiterkörpers (1) zugeordnete, flächenhafte Anschlußfahne (9) mit der Metallisierungsschicht (6) auf der Stabilisierungsplatte (4) verlötet ist.

11. Leistungshalbleiterbauelement nach einem der vorangehenden Ansprüche mit mehreren scheibenförmigen Leistungshalbleiterkörpern (1a, 1b, 1c, 1d), dadurch gekennzeichnet, daß die Stabilisierungsplatte (4) für jeden der Leistungshalbleiterkörper (1a, 1b, 1c, 1d) eine besondere Aussparung (5a, 5b, 5c, 5d) enthält, in die jeweils ein Leistungshalbleiterkörper (1a, 1b, 1c, 1d) eingefügt wird, daß die Metallisierungsschicht (6) auf der Stabilisierungsplatte (4) zur Bildung von Leitbahnen (6a, 6b, 6c) derart strukturiert ist, daß elektrische Verbindungsleitungen (7a₁, 7a₂, ...., 7d₁, 7d₂) der scheibenförmigen Leistungshalbleiterkörper (1a, ..., 1d) zwecks deren Verschaltung mit diesen Leitbahnen (6a, 6b, 6c) verbunden sind.

12. Leistungshalbleiterbauelement nach Anspruch 11, dadurch gekennzeichnet, daß jeweils eine Leitbahn (6a, 6b, 6c) mit einer flächenhaft ausgebildeten Anschlußfahne (9a, 9b, 9c) verlötet ist.

13. Leistungshalbleiterbauelement nach einem der vorangehenden Ansprüche, dadurch gekennzeichnet, daß die kupferne, erste Trägerplatte (2) eine integrierte, flächenhafte Anschlußfahne (8) aufweist.

14. Leistungshalbleiterbauelement nach einem der vorangehenden Ansprüche, dadurch gekennzeichnet, daß die isolierende, zweite Trägerplatte (3) auf einer Grundplatte (10), die zusammen mit einer Gehäusehaube das Gehäuse des Leistungshalbleiterbauelementes bildet, angeordnet ist.

15. Leistungshalbleiterbauelement nach einem der vorangehenden Ansprüche, dadurch gekennzeichnet, daß die Grundplatte (10) aus Kupfer besteht.

## Claims

1. Power semiconductor component with a low thermal resistance, in which at least one disc-like power semiconductor body (1), which is soldered to a first support plate (2) consisting of copper, is disposed on a second support plate (3), characterised in that the second support plate (3) is electrically insulating, that an electrically insulating stabilising plate (4), which is provided with a recess (5), is disposed on the first support plate (2), and that the disc-like power semiconductor body (1) is inserted in this recess (5) in the stabilising plate (4).

2. Power semiconductor component according to claim 1, characterised in that the first, copper support plate (2) consists of high-purity copper.

3. Power semiconductor component according to claim 1 or 2, characterised in that the coefficient of thermal expansion of the stabilising plate (4) is lower than that of the first, copper support plate (2).

4. Power semiconductor component according to any one of the preceding claims, characterised in that the stabilising plate (4) consists of a ceramic.

5. Power semiconductor component according to claim 4, characterised in that the stabilising plate (4) consists of aluminium oxide (Al₂O₃).

6. Power semiconductor component according to claim 5, characterised in that the stabilising plate (4) is between 0.38 and 0.63 mm thick.

7. Power semiconductor component according to any one of the preceding claims, characterised in that the first, copper support plate (2) is at least 10 mm thick.

8. Power semiconductor component according to any one of the preceding claims, characterised in that the second, insulating support plate (3) consists of aluminium oxide (Al₂O₃) or aluminium nitride (AlN).

9. Power semiconductor component according to any one of the preceding claims, in which the disc-like power semiconductor body (1) comprises at its upper side at least one electrical connection contact which covers a small area, characterised in that the stabilizing plate (4) is metallized on both sides, and that an electrical connecting wire (7) leads from the metallization layer (6) on the upper side of the stabilising plate (4) to the small-area connection contact of the power semiconductor body (1).

10. Power semiconductor component according to claim 9, characterized in that a flat connection lug (9), which is associated with the small-area connection contact on the upper side of the power semiconductor body (1), is soldered to the metallization layer (6) on the stabilizing plate (4).

11. Power semiconductor component according to any one of the preceding claims, comprising a plurality of disc-like power semiconductor bodies (1a, 1b, 1c, 1d), characterized in that the stabilizing plate (4) comprises a special recess (5a, 5b, 5c, 5d) for each power semiconductor body (1a, 1b, 1c, 1d), in which recesses each of these power semiconductor bodies (1a, 1b, 1c, 1d) is inserted, that the metallization layer (6) on the stabilizing plate (4) is structured so as to form tracks (6a, 6b, 6c) such that electrical connecting wires (7a₁, 7a₂, ...., 7d₁, 7d₂) of the disc-like power semiconductor bodies (1a, ..., 1d) are connected to these tracks (6a, 6b, 6c) for the purpose of completing the circuit.

12. Power semiconductor component according to claim 11, characterised in that each track (6a, 6b, 6c) is soldered to a flat connection lug (9a, 9b, 9c).

13. Power semiconductor component according to any one of the preceding claims, characterised in that the first, copper support plate (2) comprises an integrated, flat connection lug (8).

14. Power semiconductor component according to any one of the preceding claims, characterized in that the second, insulating support plate (3) is disposed on a base plate (10) which, together with a housing cover, forms the housing of the power semiconductor component.

15. Power semiconductor component according to any one of the preceding claims, characterized in that the base plate (10) consists of copper.

## Revendications

1. Composant à semi-conducteur de puissance présentant une faible résistance thermique, dans le cas duquel au moins un élément à semi-conducteur de puissance (1), en forme de galette, soudé sur une première plaque support (2) constituée de cuivre, est disposé sur une seconde plaque support (3), composant caractérisé par le fait que la seconde plaque support (3) est électriquement isolante, que sur la première plaque support (2) est disposée une plaque de stabilisation (4) électriquement isolante et présentant un évidement (5) et par le fait qu'en outre dans cet évidement (5) de la plaque de stabilisation (4) est inséré l'élément à semi-conducteur de puissance en forme de galette.

2. Composant à semi-conducteur de puissance selon la revendication 1, caractérisé par le fait que la première plaque support (2) en cuivre est constituée de cuivre extrêment pur.

3. Composant à semi-conducteur de puissance selon la revendication 1 ou la revendication 2, caractérisé par le fait que le coefficient de dilatation thermique de la plaque de stabilisation (4) est inférieur à celui de la première plaque support en cuivre (2).

4. Composant à semi-conducteur de puissance selon l'une des revendications précédentes, caractérisé par le fait que la plaque de stabilisation (4) est en céramique.

5. Composant à semi-conducteur de puissance selon la revendication 4, caractérisé par le fait que la plaque de stabilisation (4) est constituée d'oxyde d'aluminium (Al₂O₃).

6. Composant à semi-conducteur de puissance selon la revendication 5, caractérisé par le fait que la plaque de stabilisation (4) présente une épaisseur de 0,38 -0,63 mm.

7. Composant à semi-conducteur de puissance selon l'une des revendications précédentes, caractérisé par le fait que l'épaisseur de la première plaque support en cuivre (2) atteint au moins 10 mm.

8. Composant à semi-conducteur selon l'une des revendications précédentes, caractérisé par la fait que la seconde plaque support (3), isolante, est en oxyde d'aluminium (Al₂O₃) ou en nitrure d'alumunium (AlN).

9. Composant à semi-conducteur de puissance selon l'une des revendications précédentes, dans le cas duquel l'élément à semi-conducteur de puissance (1) en forme de galette présente, sur sa face supérieure, au moins un contact de connexion électrique étroitement limité en surface, caractérisé par le fait que la plaque de stabilisation (4) est métallisée des deux côtés et que, de la couche de métallisation (6) qui se trouve sur la face supérieure de la plaque de stabilisation (4), un conducteur de liaison électrique (7) conduit au contact de connexion, étroitement limité, de l'élément à semi-conducteur de puissance (1).

10. Composant à semi-conducteur de puissance selon la revendication 9, caractérisé par le fait qu'une cosse de connexion (9) plate, correspondant au contact de connexion, étroitement limité en surface, qui se trouve sur la face supérieure de l'élément à semi-conducteur de puissance (1), est brasée avec la couche de métallisation (6) qui se trouve sur la plaque de stabilisation (4).

11. Composant à semi-conducteur de puissance selon l'une des revendications précédentes, comportant plusieurs éléments à semi-conducteur de puissance en forme de galette (1a, 1b, 1c, 1d) caractérisé par le fait que la plaque de stabilisation (4) contient, pour chacun des éléments à semi-conducteur de puissance (1a, 1b, 1d), un évidement particulier (5a, 5b, 5c, 5d), dans chacun desquels est inséré un élément à semi-conducteur de puissance (1a, 1b, 1c, 1d), que la couche de métallisation (6) qui se trouve sur la plaque de stabilisation (4) pour former des rubans conducteurs (6a, 6b, 6c) est structurée de façon telle que des conducteurs de liaison électrique (7a₁, 7a₂, ..., 7d₁, 7d₂) des éléments à semi-conducteur de puissance en forme de galette (1a, ..., 1d) sont, aux fins de la mise en circuit de ces éléments, reliés avec ces rubans conducteurs (6a, 6b, 6c).

12. Composant à semi-conducteur de puissance selon la revendication 11, caractérisé par le fait que chacun des rubans conducteurs (6a, 6b, 6c) est brasé avec une cosse de connexion de forme plate (9a, 9b, 9c).

13. Composant à semi-conducteur de puissance selon l'une des revendications précédentes, caractérisé par le fait que la première plaque support en cuivre (2) présente une cosse de connexion intégrée plate (8).

14. Composant à semi-conducteur de puissance selon l'une des revendications précédentes, caractérisé par le fait que la seconde plaque support (3), isolante, est disposée sur une plaque de base (10) qui, avec un capot de boîtier, forme le boîtier du composant à semi-conducteur de puissance.

15. Componsant à semi-conducteur de puissance selon l'une des revendications précédentes, caractérisé par le fait que la plaque de base (10) est en cuivre.
